# EUROPEAN PATENT APPLICATION

(11) **EP 2 410 428 A2**
(43) Date of publication of application: **25.01.2012**
(21) Application number: 09841960.9
(22) Date of filing: 29.12.2009
(51) Int. Cl.: G06F 11/08, G06F 9/06

(54) **APPARATUS AND METHOD FOR MANAGING A DRAM BUFFER**

(30) Priority: 19.03.2009 KR 20090023620
(71) Applicant: Indilinx Co., Ltd., Gyeonggi-do 463-760 (KR)
(72) Inventor: JEONG, Hyoun Kwon, Seongnam-si Gyeonggi-do 463-760 (KR); KIM, Young Goan, Seongnam-si Gyeonggi-do 463-760 (KR)
(74) Representative: Desormiere, Pierre-Louis
(86) International application number: PCT/KR2009/007882
(87) International publication number: WO 2010/107176

(57) **Abstract**

An apparatus and method for managing a dynamic random access memory (DRAM) buffer are disclosed. The DRAM buffer managing apparatus and method may generate an error correction code (ECC) for data to be written in a DRAM buffer, and may write the data and the ECC in the DRAM buffer.

## Description

### Technical Field

The present invention relates to an apparatus and method for managing a dynamic random access memory (DRAM) buffer, and more particularly, to an apparatus and method for managing a DRAM buffer that may apply an error correction code (ECC) to the DRAM buffer.

### Background Art

A storage device for storing data may include, for example, a magnetic disk, a semiconductor memory, and the like. Since physical characteristics are different for each type of storage device, a management method corresponding to the distinctive physical characteristics is required.

Conventionally, magnetic disks are widely used as storage devices. A read/write time of the magnetic disk takes an average of several milliseconds per kilobyte. Additionally, since an arrival time of an arm of the magnetic disk is different depending on a physical location where data is stored, the read/write time of the magnetic disk varies.

Recently, a non-volatile memory that takes a relatively short read/write time, consumes a small amount of power, and occupies a small amount of space, when compared to a magnetic disk, is rapidly replacing the magnetic disk. This is due to an increase in the capacity of the non-volatile memory.

The non-volatile memory may electrically perform reading, writing, and erasing. The non-volatile memory is a semiconductor memory device that is able to maintain stored data even when power is interrupted. A process of storing data in a non-volatile memory device is additionally referred to as programming, as well as writing.

A typical example of the non-volatile memory includes a flash memory. The flash memory has advantages of a small size, a low power consumption, and a high read rate, when compared to a conventional Hard Disk Drive (HDD). Recently, a Solid State Disk (SSD) using a high-capacity flash memory was proposed to replace an HDD.

The flash memory may typically include, for example, a NAND-type flash memory, a NOR-type flash memory, and the like. A NAND scheme and a NOR scheme may be distinguished based on a configuration and an operating scheme of a cell array.

A flash memory includes an array of a plurality of memory cells, and a single memory cell may store at least one data bit. A single memory cell includes a control gate and a floating gate, and an insulator is inserted between the control gate and the floating gate. An insulator is also inserted between the floating gate and a substrate.

The non-volatile memory is managed by a predetermined controller. Additionally, an overall performance of the non-volatile memory may be determined based on a performance of the controller.

Accordingly, there is a desire for research on a method that may efficiently manage and control a memory.

### Disclosure of Invention

### Technical Goals

An aspect of the present invention provides an apparatus and method for managing a dynamic random access memory (DRAM) buffer that may apply an error correction code (ECC) to the DRAM buffer without a separate device.

### Technical solutions

According to an aspect of the present invention, there is provided an apparatus for managing a dynamic random access memory (DRAM) buffer, the apparatus including an error correction code (ECC) generator to generate an ECC for data to be written in a DRAM buffer, and a writer to write the data and the ECC in the DRAM buffer.

According to another aspect of the present invention, there is provided a method of managing a DRAM buffer, the method including generating an ECC for data to be written in a DRAM buffer, and writing the data and the ECC in the DRAM buffer.

### Effect of Invention

According to an aspect of the present invention, an apparatus and method for managing a dynamic random access memory (DRAM) buffer, that may generate an error correction code (ECC) for data to be written in the DRAM buffer, and may write the data and the ECC in the DRAM buffer, may be provided, thereby applying an ECC in a DRAM buffer without a separate device.

### Brief Description of Drawings

FIG. 1 is a diagram illustrating a configuration of an apparatus for managing a dynamic random access memory (DRAM) buffer according to embodiments of the present invention.
FIG. 2 is a flowchart illustrating a method of managing a DRAM buffer according to embodiments of the present invention.

### Best Mode for Carrying Out the Invention

Reference will now be made in detail to embodiments of the present invention, examples of which are illustrated in the accompanying drawings, wherein like reference numerals refer to the like elements throughout. The embodiments are described below in order to explain the present invention by referring to the figures.

Generally, programming of a non-volatile memory may be performed in page units and erasing may be performed in block units. Here, a block may include a plurality of pages.

Also, a memory controller for managing the non-volatile memory may provide a logical address to an external host or a processor, and may provide a physical address with respect to the non-volatile memory.

In this instance, the memory controller may manage the non-volatile memory using the physical address, and may convert the physical address into the logical address.

Here, a layer in which converting of the physical address and the logical address is performed is referred to as a Flash Translation Layer (FTL).

Due to problems regarding a demand for a bandwidth and consumed power that are recently increasing in an enterprise server market, a scheme of using a Solid State Disk(SDD), rather than a Hard Disk Drive (HDD), as a data storage device is being introduced intrepidly.

An initial SSD controller uses an internal memory as a data buffer, however, a recent SDD controller generally uses a dynamic random access memory (DRAM) as a data buffer because of a demand for high speed.

A majority of servers used by enterprises have a DRAM module in which a high-priced error correction code (EDD) functionality is applied as a main memory of a system bus for stability of data.

Thus, when a DRAM is used as a data buffer in an SSD to be used in a server, using a DRAM module with an ECC functionality may be advantageous for stability of data.

In this instance, the ECC DRAM module generally includes an ECC-only DRAM chip to store a separate ECC within a Small Outline Dual In-line Memory Module (SODIMM).

However, in case of the SSD, a buffer to be actually used has a relatively small size, and it is difficult to use more than one DRAM chip in an aspect of cost.

Additionally, in an aspect of an amount of power used for a separate ECC-only DRAM chip, it may be difficult to use a separate DRAM chip in a single SSD.

With regard to this, when a DRAM is used as a data buffer or a cache, a DRAM buffer managing apparatus according to embodiments of the present invention may generate an ECC for data to be written in a DRAM buffer, and may write both the data and the ECC in the DRAM buffer, thereby applying an ECC solution to DRAM data without an additional device.

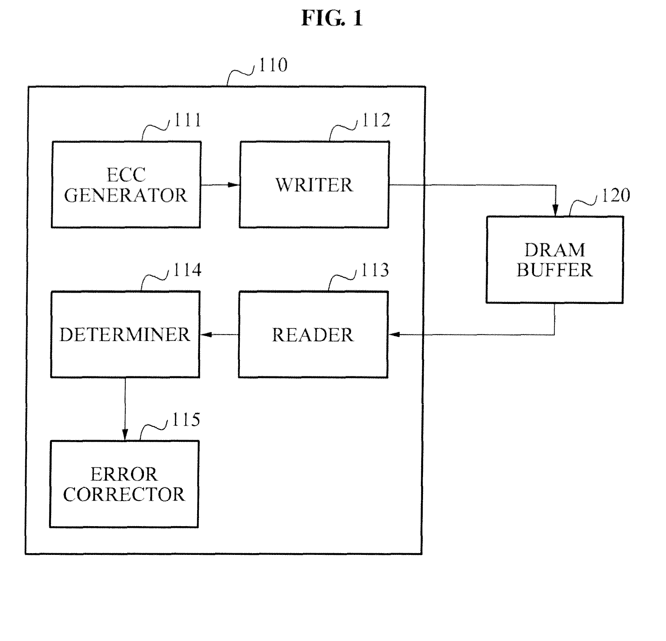

Accordingly, the DRAM buffer managing apparatus will be further described hereinafter with reference to FIG. 1.

FIG. 1 is a diagram illustrating a configuration of an apparatus 110 of managing a DRAM buffer 120 according to embodiments of the present invention.

Referring to FIG. 1, the DRAM buffer managing apparatus 110 and the DRAM buffer 120 are illustrated.

The DRAM buffer managing apparatus 110 may include an ECC generator 111 and a writer 112.

The ECC generator 111 may generate an ECC for data to be written in the DRAM buffer 120.

The writer 112 may write the data and the ECC in the DRAM buffer 120.

In this instance, when the writer 112 writes the data and the ECC in the DRAM buffer 120, a sum of a size of the data and a size of the ECC may exceed a size of a first page in the DRAM buffer 120 in which the data and the ECC may be written.

With regard to this, the DRAM buffer managing apparatus 110 may further include a table storage unit (not shown) to store an address mapping table in which successive pages, among at least one page constituting the DRAM buffer 120, may be respectively mapped to different banks.

In this instance, when the sum of the size of the data and the size of the ECC exceeds the size of the first page in which the data and the ECC may be written, the writer 112 may open a row included in a second page following the first page by referring to the address mapping table, and may write data corresponding to the excess of the size of the first page, among the data and the ECC, in the second page.

Accordingly, the ECC and the data may be transmitted to the DRAM buffer 120, and the DRAM buffer managing apparatus 110 may prevent a potential loss of a transmission bandwidth.

The DRAM buffer managing apparatus 110 may further include a reader 113, a determiner 114, and an error corrector 115.

The reader 113 may read the data and the ECC from the DRAM buffer 120.

The determiner may determine whether an error occurs in the read data, based on the read ECC.

For example, the determiner may generate an ECC for the read data based on an ECC generation algorithm used by the ECC generator 111 to generate the read ECC.

The determiner 114 may determine whether an error occurs in the read data, by comparing the read ECC and the ECC for the read data.

The error corrector may correct the error when an error occurs in the read data.

The following description will be further described using the DRAM buffer managing apparatus 110 as an example.

Here, an example of the DRAM buffer managing apparatus 110 applied to an SSD will be used.

The DRAM buffer managing apparatus 110 may be included in an SSD controller.

Generally, the SSD controller and the DRAM buffer 120 may transmit and receive data using a burst operation.

That is, the SSD controller may transmit data to the DRAM buffer 120 in burst units.

It may be assumed that the SSD controller may transmit data to the DRAM buffer 120 in N burst units.

As an example, an operation of the DRAM buffer managing apparatus 110 when the SSD controller writes the data in the DRAM buffer 120 will be described.

The generator 111 may generate an ECC for N-burst data to be transmitted to the DRAM buffer 120, in real time.

The writer 112 may successively transmit the N-burst data and the ECC to the DRAM buffer 120, and may write the N-burst data and the ECC in the DRAM buffer 120.

When the ECC corresponds to M-burst data, the writer 112 may transmit the N-burst data and the ECC to be written in the DRAM buffer 120 within the same burst operation, thereby converting a transmission configuration of the N-burst data to a transmission configuration of N + M burst data.

The DRAM buffer managing apparatus 110 may increase a basic burst unit of data to be transmitted from the DRAM buffer managing apparatus 110 to the DRAM buffer 120 to a size of the ECC, and may store the data and the ECC in a single DRAM chip through a single burst access.

In this instance, when the DRAM buffer managing apparatus 110 transmits the data to the DRAM buffer 120 by incorporating the ECC into the DATA, a single burst transmission may use at least one page in the DRAM buffer 120.

In other words, a sum of a size of the data and a size of the ECC may exceed a size of a first page in which the data and the ECC may be written.

The DRAM buffer managing apparatus 110 may further include a table storage unit to store an address mapping table in which successive pages, among at least one page constituting the DRAM buffer 120, may be respectively mapped to different banks.

In this instance, when the sum of the size of the data and the size of the ECC exceeds the size of the first page, the writer 112 may open a row included in a second page, following the first page and mapped in a bank different from a bank of the first page, by referring to the address mapping table, and may write data corresponding to the excess of the size of the first page, among the data and the ECC, in the second page, thereby transmitting the data from the DRAM buffer managing apparatus 110 to the DRAM buffer 120 without of a burst.

The DRAM buffer managing apparatus 110 may enable bank interleaving using the address mapping table, thereby preventing a loss of a transmission bandwidth between the DRAM buffer managing apparatus 110 and the DRAM buffer 120.

As another example, an operation of the DRAM buffer managing apparatus 110 when the SSD controller reads, from the DRAM buffer 120, the data written by the aforementioned method will be described.

The reader 113 may read the data and the ECC from the DRAM buffer using an N + M burst.

The determiner 114 may check the read ECC in real time, and may determine whether an error occurs in the read data, a location of an error bit, and the like, based on the read ECC.

When an error occurs in the read data, the error corrector 115 may correct the error by receiving location information of the error bit, or error content information, and the like from the determiner 114.

According to embodiments of the present invention, the DRAM buffer managing apparatus 110 may further include an instruction controller (not shown) to reorder a sequence of data request instructions transmitted from a plurality of masters so that bank interleaving of the sequence of the data request instructions may be possible.

The instruction controller may enable the bank interleaving between a current instruction and a next instruction, and may previously open a row for the next instruction during data transmission of the current instruction, thereby increasing an overall transmission bandwidth of the DRAM buffer 120.

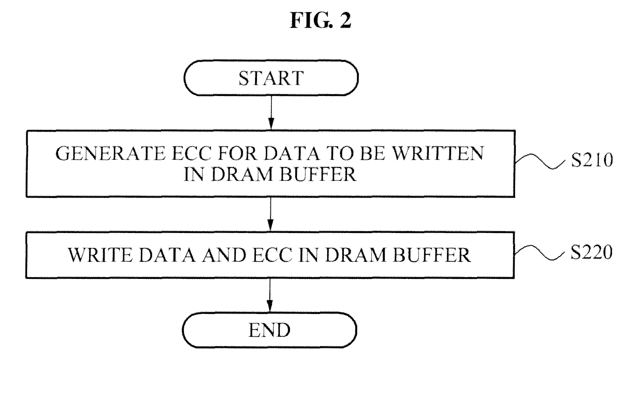

FIG. 2 is a flowchart illustrating a method of managing a DRAM buffer according to embodiments of the present invention.

In operation S210, an ECC for data to be written in a DRAM buffer may be generated.

In operation 220, the data and the ECC may be written in the DRAM buffer.

When the data is read from the DRAM buffer, the DRAM buffer managing method may further include reading the data and the ECC from the DRAM buffer after operation S220.

The DRAM buffer managing method may further include determining whether an error occurs in the read data based on the read ECC.

The DRAM buffer managing method may further include correcting an error when the error occurs in the read data.

Also, operation S220 may include determining whether a sum of a size of the data and a size of the ECC exceeds a size of a first page in which the data and the ECC may be written.

When the sum of the size of the data and the size of the ECC exceed the size of the first page, operation S220 may include opening a row included in a second page following the first page by referring to an address mapping table, and writing data corresponding to the excess of the size of the first page, among the data and the ECC, in the second page.

In this instance, the address mapping table may correspond to a table in which successive pages, among at least one page constituting the DRAM buffer, may be respectively mapped to different banks.

The DRAM buffer managing method has been described with reference to FIG. 2. Here, the DRAM buffer managing method may correspond to the configuration of the DRAM buffer managing apparatus described with reference to FIG. 1, and accordingly a further description will be omitted.

The DRAM buffer managing method according to embodiments of the present invention may be recorded in computer-readable media including program instructions to implement various operations embodied by a computer. The media may also include, alone or in combination with the program instructions, data files, data structures, and the like. Examples of computer-readable media include magnetic media such as hard disks, floppy disks, and magnetic tape; optical media such as CD ROM discs and DVDs; magneto-optical media such as floptical discs; and hardware devices that are specially configured to store and perform program instructions, such as read-only memory (ROM), random access memory (RAM), flash memory, and the like. Examples of program instructions include both machine code, such as produced by a compiler, and files containing higher level code that may be executed by the computer using an interpreter. The described hardware devices may be configured to act as one or more software modules in order to perform the operations of the above-described exemplary embodiments of the present invention, or vice versa.

Although a few embodiments of the present invention have been shown and described, the present invention is not limited to the described embodiments. Instead, it would be appreciated by those skilled in the art that changes may be made to these embodiments without departing from the principles and spirit of the invention, the scope of which is defined by the claims and their equivalents.

## Claims

1. An apparatus for managing a dynamic random access memory (DRAM) buffer, the apparatus comprising:
an error correction code (ECC) generator to generate an ECC for data to be written in a DRAM buffer; and
a writer to write the data and the ECC in the DRAM buffer.

2. The apparatus of claim 1, further comprising:
a reader to read the data and the ECC from the DRAM buffer;
a determiner to determine whether an error occurs in the read data, based on the read ECC; and
an error corrector to correct the error when an error occurs in the read data.

3. The apparatus of claim 1, further comprising:
a table storage unit to store an address mapping table in which successive pages, among at least one page constituting the DRAM buffer, are respectively mapped to different banks.

4. The apparatus of claim 3, wherein, when a sum of a size of the data and a size of the ECC exceeds a size of a first page in which the data and the ECC are to be written, the writer opens a row included in a second page following the first page by referring to the address mapping table, and writes data corresponding to the excess of the size of the first page, among the data and the ECC, in the second page.

5. The apparatus of claim 1, wherein
the ECC generator generates in real time the ECC at every burst (unit) when the data is transmitted to the DRAM buffer in burst units, and
the writer successively transmits the data and the ECC to the DRAM buffer at every burst unit.

6. A method of managing a dynamic random access memory (DRAM) buffer, the method comprising:
generating an error correction code (ECC) for data to be written in a DRAM buffer; and
writing the data and the ECC in the DRAM buffer.

7. The method of claim 6, further comprising:
reading the data and the ECC from the DRAM buffer;
determining whether an error occurs in the read data, based on the read ECC; and
correcting the error when an error occurs in the read data.

8. The method of claim 6, wherein
the writing comprises:
determining whether a sum of a size of the data and a size of the ECC exceeds a size of a first page in which the data and the ECC are to be written; and
opening a row included in a second page following the first page by referring to an address mapping table, and writing data corresponding to the excess of the size of the first page, among the data and the ECC, in the second page when the sum of the size of the data and the size of the ECC exceeds the size of the first page, and
the address mapping table corresponds to a table in which successive pages, among at least one page constituting the DRAM buffer, are respectively mapped to different banks.

9. A computer-readable recording medium storing a program to implement the method of any one of claim 6 to 8.
